**Europäisches Patentamt**

**European Patent Office**

**Office européen des brevets**

(19)

(11) Veröffentlichungsnummer: **0 118 583**
**A1**

(12) # EUROPÄISCHE PATENTANMELDUNG

(21) Anmeldenummer: **83102634.9**

(22) Anmeldetag: **17.03.83**

(51) Int. Cl.³: **G 06 F 11/20**

(43) Veröffentlichungstag der Anmeldung:
**19.09.84 Patentblatt 84/38**

(84) Benannte Vertragsstaaten:
**BE CH FR IT LI NL SE**

(71) Anmelder: **Coza, Georg V.**
**Holdergasse 26**
**D-7141 Schwieberdingen(DE)**

(72) Erfinder: **Coza, Georg V.**
**Holdergasse 26**
**D-7141 Schwieberdingen(DE)**

(74) Vertreter: **Dreiss, Uwe, Dr. jur. Dipl.-Ing. M.Sc. et al,**
**Patentanwälte Dreiss, Hosenthien & Fuhlendorf**
**Gerokstrasse 6**
**D-7000 Stuttgart 1(DE)**

(54) **Speicher-Korrektureinheit.**

(57) Es wird ein Verfahren und eine Vorrichtung vorgeschlagen, die zum Abspeichern des Speicherinhaltes defekter Speicherzellen dient. Wird erkannt, daß eine Speicherzelle defekt ist, so werden in eine intakte Speicherzelle unter einer Ersatzadresse die Daten und die ursprüngliche Adresse (Uradresse) abgespeichert. Mit einem im System sich wiederholenden Ereignis werden die Uradressen in eine Speicherkorrektureinheit übertragen und mit den von den Recheneinheit aufgerufenen Adressen verglichen. Tritt eine Übereinstimmung auf, so wird nicht die Uradresse sondern die Ersatzadresse aufgerufen.

Fig. 3

EP 0 118 583 A1

Croydon Printing Company Ltd.

Beschreibung

Die Erfindung geht aus von einem Verfahren zur Datensicherung, insbesondere EPROMs, wenn eine Veränderung der Datenzelle zu erwarten ist oder stattfindet.

Aus der DE-OS 28 53 925 ist bereits bekannt, daß Speichereinheiten, insbesondere EPROMs, ihre Ladung, insbesondere bei hohen Temperaturen, ändern. Eine von vielen möglichen Ursachen ist, daß bei einer Speicherzelle das Gate eines Feldeffekttransistors nicht mehr genügend isoliert und aus diesem Grunde Ladungsträger abfließen können. Andererseits kann durch die Hitzeentwicklung jedoch auch der umgekehrte Fall auftreten, daß nämlich Ladungsträger auf eine bestimmte Speicherzelle aufgebracht werden, weil beispielsweise die Isolierung zur Umgebung an dieser Stelle defekt ist. Hierbei treten schleichende Ladungsänderungen auf. Sie bewirken, daß die Ladung nach einer gewissen Zeit verloren geht. Eine Möglichkeit, dies zu verhindern, ist in der DE-OS 28 53 925 beschrieben.

0118583

Bei einem Bordrechner für Kraftfahrzeuge wird durch eine Refresh-Schaltung ein EPROM in regelmäßigen Abständen neu programmiert. Dieses Verfahren ist jedoch nur anwendbar, wenn die entsprechenden Speicherzellen an sich noch intakt sind. Die Neuprogrammierung einer Speicherzelle führt dann nicht zum gewünschten Erfolg, wenn die Zelle selbst defekt ist und der Datenverlust nicht durch äußere Umstände bedingt ist.

Weiter ist es bekannt, zum Schutz gegen Datenverluste redundante Verfahren zu wählen. Eine Möglichkeit ist beispielsweise, die Daten doppelt in einem entsprechend großen Speicher abzulegen und beispielsweise mittels Quersummenbildung festzustellen, welcher Datensatz von beiden Speichern gegebenenfalls einwandfrei ist. Dies erfordert jedoch eine hohe Anzahl von Speicherplätzen.

Aufgabe der Erfindung ist es, eine SpeicherKorrektureinheit der genannten Art so weiterzubilden, daß die geschilderten Nachteile nicht auftreten; es soll in besonders einfacher Weise vermieden werden, daß Datenverluste auftreten als Frage des Verlustes der Funktionsfähigkeit von Speicherzellen.

Das erfindungsgemäße Verfahren ist, dadurch gekennzeichnet, daß die unter der ursprünglichen Adresse abgelegte Information unter einer Ersatzadresse zusammen mit der ursprünglichen Adresse gespeichert ist.

Dies hat den Vorteil, daß nur Daten solcher Adressen, bei denen erkannt ist, daß sich ihr Dateninhalt ändert, zusammen mit der Ursprungsadresse in einer Ersatzadresse abgespeichert werden. Da bei Speichereinheiten üblicherweise nur eine ganz geringe Anzahl von Speicherzellen ausfallen, wird dadurch erreicht, daß nur eine minimale Anzahl von zusätzlichen Speicherzellen erforderlich ist, um die Betriebssicherheit der Recheneinheit und der in der Speichereinheit gespeicherten Programme für lange Zeit zu gewährleisten.

In den Unteransprüchen sind vorteilhafte Weiterbildungen und Verbesserungen des angegebenen Verfahrens definiert. So ist es günstig, bei
einer vorgegebenen Anzahl von belegten Ersatzadressen ein Signal abzugeben. Da die Anzahl
der Ersatzadressen naturgemäß beschränkt ist,
müssen vorteilhafter Weise Maßnahmen getroffen
werden, die erkennen lassen, wenn in dem Ursprungsspeicher eine größere Anzahl von Speicherzellen ausfallen. Weiterhin ist es vorteilhaft,
die Ersatzadressen in einem Korrekturspeicher
anzuordnen, der Teil des Programm- und/oder Datenspeichers ist. Durch diese Maßnahme wird erreicht, daß zusätzliche Speicherbausteine nicht
erforderlich sind. Der Korrekturspeicher ist
Bestandteil eines bereits vorhandenen Speicherbausteins, von dem ein Teil der Speicherplätze
für Korrekturen reserviert ist. Weitere vorteilhafte Ausgestaltungen sind, den Korrekturspeicher in die Speicherkorrektureinheit einzubeziehen oder einen separaten Speicher zu verwenden.
Die Ersatzadresse ist vorteilhaft im Korrekturspeicher mit der Ursprungsadresse voll korreliert.
Dadurch wird erreicht, daß bei der Bearbeitung
eines Programmes beim Aufruf der Uradresse sofort die Ersatzadresse für die Uradresse zugeordnet und angesprungen wird. Weiterhin ist es günstig, die Ersatzadressen als Abstand zur End- oder Anfangsadresse des Korrekturspeichers ansprechbar zu machen. Durch diese Maßnahmen ist Speicherplatz in dem Ersatzadressregisterblock einsparbar, da nur die Differenz anzugeben ist, so daß die Anzahl der Adressbits pro Adresse kleiner ist als wenn die Ersatzadresse vollständig angegeben ist. Vorteilhaft ist es weiterhin, die Daten in der Speicherkorrektureinheit unmittelbar neben der Uradresse abrufbar auszubilden.

Für die Vorrichtung zur Datensicherung ist vorteilhaft zwischen der Recheneinheit und dem Datenspeicher eine Speicherkorrektureinheit vorgesehen, die einen Vergleicher aufweist, in dem die aufgerufene Adresse mit den als defekt bekannten Adressen verglichen wird, wobei bei gleichen Adressen ein Signal abgegeben wird, so daß die Ersatzadresse aufgerufen wird. Dies ist eine einfache, leicht zu realisierende Maßnahme, um zu erkennen, ob beim Aufruf einer Adresse mit defekten Daten die Ersatzadressen anzusprechen ist.
Die Speicherkorrektureinheit weist vorteilhafterweise Register auf, in denen Adressen und Daten
ablegbar sind. Weiterhin ist es günstig, Speicherplätze vorzusehen, in denen Ursprungsadressen
und Ersatzadressen oder Daten oder Abstände von
End- oder Anfangsadressen ablegbar sind. Dadurch
wird erreicht, daß auch eine schnelle Zuordnung
zwischen Ursprungsadresse und Ersatzadresse gegeben ist. Weiterhin ist es vorteilhaft, Vorrichtungen zur Steuerung der Register vorzusehen, durch
die Adressen zurückhaltbar und/oder austauschbar
sind. Diese Maßnahme dient zur vorteilhaften Ansteuerung der Speichereinrichtung durch den Mikroprozessor über die Speicherkorrektureinheit.

Ein Ausführungsbeispiel der Erfindung ist in der
Zeichnung dargestellt und in der nachfolgenden
Beschreibung näher erläutert. Es zeigen:

Figur 1    eine Recheneinheit mit Speicher und
           Speicherkorrektureinheit;

Figur 2    ein Beispiel für die Organisation der Daten in der Speichereinheit;


Figur 3    ein Beispiel einer vorteilhaften Ausgestaltung einer Speicherkorrektureinheit.


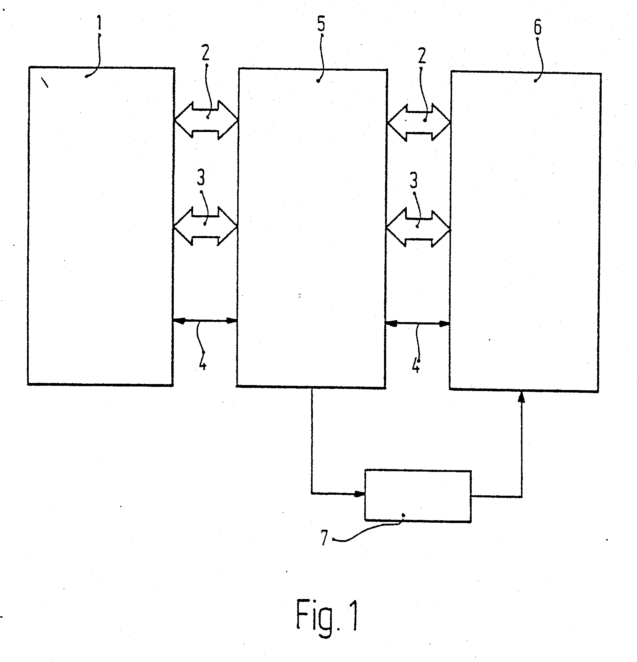

Figur 1 zeigt eine Recheneinheit 1, die über Datenleitungen 2, Adressleitungen 3 und Steuerleitungen 4 mit einer Speicherkorrektureinheit 5 in Verbindung steht. Die Speicherkorrektureinheit 5 steht über Datenleitungen 2, Adressleitungen 3 und Steuerleitungen 4 mit der Speichereinheit 6 in Verbindung. Als Speichereinheit 6 eignen sich insbesondere Festwertspeicher, deren Speicherinhalt programmierbar ist. Dies sind beispielsweise PROMs, EPROMs, EEPROMs, wie sie von der Firma Intel unter der Bezeichnung 3636, 2716, 2316 vertrieben werden.

Mit der Speicherkorrektureinheit 5 und dem Speicher 6 ist noch eine Programmiereinheit 7 verbunden, die von der Recheneinheit 1 steuerbar ist. Sie dient dazu, die Ersatzadresse mit den entsprechenden Datensätzen zu belegen. Die Speicherkorrektureinheit 5 ist ein Glied zwischen dem in der Recheneinheit 1 enthaltenen Adressenzähler und dem Programm- und Datenspeicher 6. Die Speicherkorrektureinheit 5 kann entweder mit auf der Recheneinheit oder mit auf dem Speicher untergebracht sein oder als separater Baustein realisiert werden. Möglich ist auch die Zusammenfassung von Recheneinheit 1, Speicherkorrektureinheit 5 und Speicher 6 auf einem Chip. Durch eine Schaltungsanordnung zur Fehlererkennung, wie sie beispielsweise in der deutschen Patentanmeldung P 31 34 995.1 beschrieben ist, werden sich anbahnende Informationsverluste im Speicher 6 erkannt, bevor diese selbst aufgetreten sind. Andere Fehlererkennungs- und lokalisierungsverfahren können angewendet werden. Die unter der ursprünglichen Adresse $N_i$, im folgenden Uradresse genannt, korrekte Information $D_i$ wird beim Erkennen eines Fehlers in den Korrekturspeicher unter einer Ersatzadresse $N_i'$ zusammen mit der Uradresse geladen. Für diesen Ladevorgang ist die zusätzliche Programmiereinheit 7 notwendig, die beispielsweise entsprechend der DE-OS 28 53 925 ausgebildet sein kann.

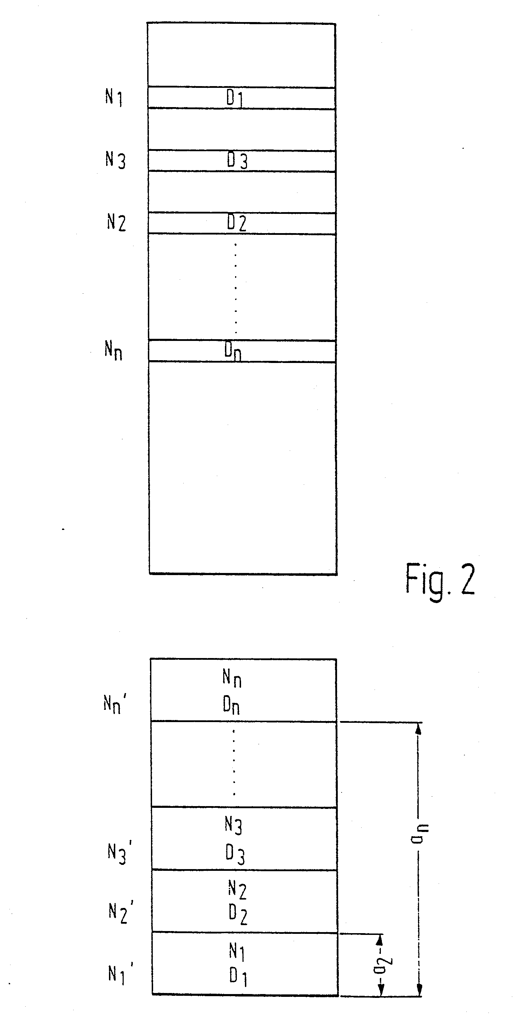

Der Korrekturspeicher selbst kann Teil des Programm- und Datenspeichers sein, er kann aber auch in der Speicherkorrektureinheit selbst untergebracht sein. Weitere Fehler im Speicher 6 werden entsprechend behandelt. Eine Möglichkeit der Organisation des Speichers 6 ist in Figur 2 dargestellt. Im oberen Bereich des Speichers 6 ist das Steuerprogramm mit Daten abgespeichert. In einem weiteren Bereich des Datenspeichers 6 sind die Adressen $N_1'$ bis $N_n'$ aufgebracht, wobei diese Ersatzadressen neben der Ursprungsadresse $N_1$ bis $N_n$ die Daten $D_1$ bis $D_n$ beinhalten. Der Korrekturspeicher weist zahlenmäßig sehr viel weniger Speicherplätze auf, als dies beim Programm- und Datenspeicher der Fall ist. Um zu verhindern, daß der Korrekturspeicher durch den Eintrag neuer Informationen überfüllt wird, wird dies in der Recheneinheit 1 festgestellt, wenn der Korrekturspeicher bis auf wenige Plätze gefüllt ist, da in diesem Falle ein Austausch der Speichereinheit 6 nicht zu umgehen ist. Mit einem im Rechensystem sich wiederholenden Ereignis, z.B. Reset, Initialisierung, werden die in den Korrekturspeicher eingetragenen Uradressen $N_i$ in speziell dafür vorgesehene Register übertragen und mit der von der Recheneinheit ausgegebenen Adresse verglichen. Tritt eine Übereinstimmung zwischen einer der abgespeicherten Adressen $N_i$ und der aktuellen Adresse auf, so wird nicht die Adresse $N_i$ sondern die Ersatzadresse $N_i'$ angesprochen. Das Ansprechen der Adresse $N_i'$ kann dadurch erfolgen, daß statt der Adresse $N_i$ die Adresse $N_i'$ an den Speicher weitergegeben ist oder daß in der Speicherkorrektureinheit der Abstand der Adresse von einer Referenzadresse angegeben ist. Das Angeben eines Abstandes hat den Vorteil, daß Speicherplatz gespart werden kann, da der Abstand mit weniger Bits angegeben werden kann als die vollständige Adresse. Zwei Beispiele, nämlich der Abstand $a_2$ und der Abstand $a_n$ sind in der Figur 2 eingezeichnet. Zum Ansprechen der Ersatzadresse ergeben sich daher folgende Möglichkeiten: Einmal ist es möglich, die Ersatzadresse vollständig anzugeben, oder es wird der Abstand zum Ende oder Anfang des Korrekturspeichers angegeben, wobei es notwendig ist, die Referenzadresse zusätzlich abzuspeichern, falls der Programm- und Datenspeicher und der Korrekturspeicher eine Einheit bilden.

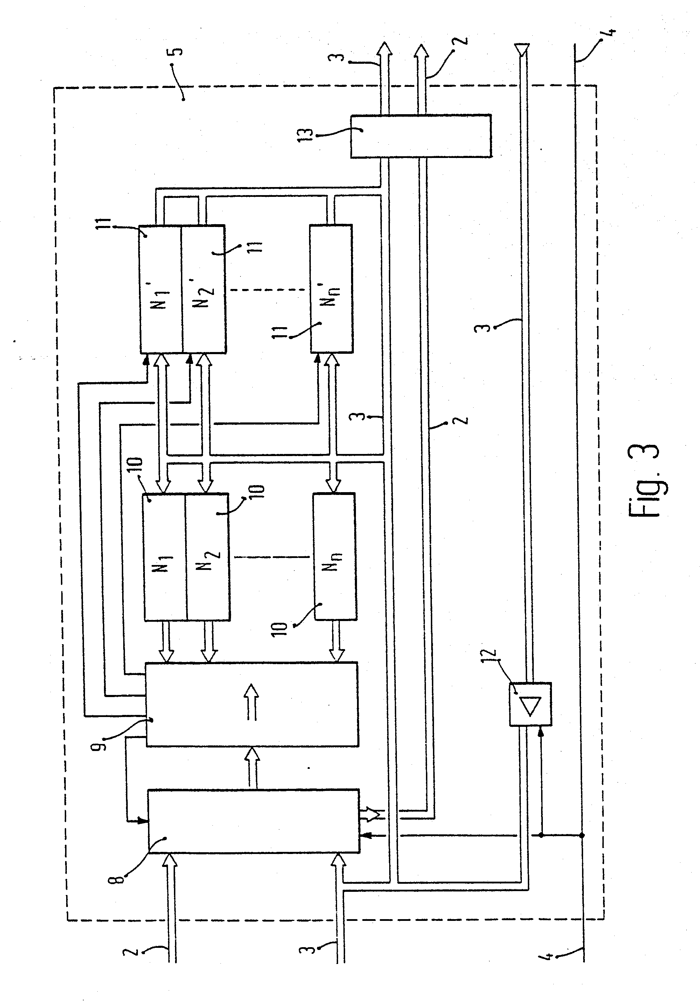

Die Speicherkorrektureinheit 5 ist in größerem Detail in der Figur 3 dargestellt .. Es sind die Datenleitungen 2, die Adressenleitungen 3 sowie die Steuerleitungen 4 erkennbar, die zur Speicherkorrektureinheit 5 führen und diese verlassen. Die Ansteuerung für die Programmierschaltung 7 ist der besseren Überssicht wegen weggelassen. Die Adressleitungen 3, die vom Rechner 1 kommen, führen zu einem Eingangsregister 8. Die Adressen werden im Vergleicher 9 mit den Uradressen verglichen, die in den Uradressregistern 10 gespeichert sind. Zu diesem Zweck stehen die Adressregister 10 mit dem Vergleicher in Verbindung. Werden keine gleichen Adressen festgestellt, wird die Adressleitung 3 zum Ausgangsregister 13 durchgesteuert. Ist die Adresse im Eingangsregister 8 gleich mit einer Adresse im Adressregister 10, so wird die Adresse des Eingangsregisters 8 gesperrt und statt dessen eine in einem entsprechenden Ersatzadressregister 11 gespeicherte Ersatzadresse an das Ausgangsregister 13 durchgeschaltet. Die Steuerung dieser Vorgänge erfolgt über Steuerleitungen, die vom Vergleicher 9 zum Eingangsregister 8 und zu den Ersatzadressregistern 11 führen.

Die durch die ursprünglichen Adressen oder Ersatzadressen aufgerufenen Daten werden über die Datenleitung 3 und den Puffer 12 ausgelesen. Die Steuerleitung 4 übernimmt die Steuerung der notwendigen Vorgänge.

In den Ersatzadressregistern 11 kann statt der Ersatzadresse auch der Abstand von einer Referenzadresse gespeichert sein. Diese Eingabe benötigt üblicherweise eine geringere Anzahl von Bits. Je- doch ist ein Rechenwerk erforderlich, das aus dieser Angabe zusammen mit der Referenzadresse die Ersatzadresse ermittelt, die angesprochen werden muß. Eine weitere Möglichkeit besteht darin, in das Ersatzadressregister 11 die Daten $D_i$ un-

mittelbar einzulesen. In diesem Fall kann die Angabe der Ersatzadresse $N_i'$ in der Speicherkorrektureinheit wegfallen. Beim Laden der Uradresse $N_i$ in die Speicherkorrektureinheit muß stattdessen die dazugehörige Information $D_i$ geladen werden. Dies führt zu einer besonders kompakten Abspeicherung in den Ersatzadressen. Jedoch ist hier Voraussetzung, daß der Datensatz nicht größer ist als die Adresse.

Durch das beschriebene Verfahren sind sowohl Ladungsverlustfehler als auch falsche Aufladungen zu korrigieren. Eine Überprogrammierung findet nicht statt. Ein weiterer Vorteil ist, daß nicht regelmäßig prophylaktisch sondern gezielt neu programmiert wird. Gegenüber den sonst üblichen Verfahren zeichnet sich das System durch eine wesentlich geringere Redundanz aus.

- Ende der Beschreibung -

0819 002

| Amtl. Akt. Z. | Ihr Zeichen | Unser Zeichen | Datum |
| Off. Ser. No. | Your Ref. | Our Ref. | Date |
| | | 0819 002 | 16. März 1983  D/m |

<u>Titel</u>: Speicher-Korrektureinheit

<u>Patentansprüche</u>

1. Verfahren zur Datensicherung von Speichern,
   insbesondere EPROMs, wenn eine Veränderung
   der Datenzelle zu erwarten ist oder stattfindet,
   <u>dadurch gekennzeichnet</u>, daß die unter der ursprünglichen Adresse (N) abgelegte Information
   (D) unter einer Ersatzadresse (N') zusammen
   mit der ursprünglichen Adresse (N) gespeichert
   ist.

2. Verfahren nach Anspruch 1, <u>dadurch gekennzeichnet,</u>

daß die Ersatzadressen (N') in einem
Korrekturspeicher angeordnet sind, der Teil
des Programms- und/oder Datenspeichers ist.

3. Verfahren nach Anspruch 1 oder 2, <u>dadurch
gekennzeichnet</u>, daß die Ersatzadressen (N')
in der Speicherkorrektureinheit (5) vollständig angegeben sind.

4. Verfahren nach einem der Ansprüche 1 bis 3,
<u>dadurch gekennzeichnet</u>, daß die Ersatz-
adressen (N') in der Speicherkorrektureinheit (5) als Abstand zur End- oder Anfangsadresse des Korrekturspeichers ansprechbar
sind.

5. Verfahren zur Datensicherung von Speichern,
insbesondere EPROMs, wenn eine Veränderung
der Datenzelle zu erwarten ist oder stattfindet, <u>dadurch gekennzeichnet</u>, daß die unter
der ursprünglichen Adresse (N) abgelegte
Information (D) unter einer Ersatzadresse (N')
gespeichert ist und die Daten in der Speicherkorrektureinheit (5) unmittelbar unter der Uradresse abrufbar sind.

6. Verfahren nach einem der Anprüche 1 bis 5,
   _dadurch gekennzeichnet_, daß bei einer vorgegebenen Anzahl von belegten Ersatzadressen
   ein Signal abgegeben wird.

7. Vorrichtung zur Datensicherung von Speichern
   nach einem der Anprüche 1 bis 6, _dadurch ge-_
   _kennzeichnet_, daß zwischen einer Recheneinheit (1) und einem Datenspeicher (6) eine
   Speicherkorrektureinheit (5) vorgesehen ist,
   die einen Vergleicher (9) aufweist, in dem
   aufgerufene Adressen mit den als defekt erkannten Adressen verglichen werden und der
   bei gleichen Adressen ein Signal abgibt, so
   daß die Ersatzadresse (N') angesprochen wird.

8. Vorrichtung nach Anspruch 7, _dadurch ge-_
   _kennzeichnet_, daß Register (9, 13) vorgesehen
   sind, in denen Adressen  und/oder Daten ablegbar sind.

- 4 -

9. Vorrichtung nach Anspruch 7 oder 8, <u>dadurch gekennzeichnet</u>, daß Register (10, 11) vorgesehen sind, in denen die Ursprungsadresse (N) und die Ersatzadresse (N') oder Daten (D) oder Abstände (a) ablegbar sind.

10. Vorrichtung nach einem der Ansprüche 7 bis 9, <u>dadurch gekennzeichnet</u>, daß Vorrichtungen zur Steuerung der Register (8, 13) vorgesehen sind, durch die Adressen zurückhaltbar und/oder austauschbar sind.

- Ende der Ansprüche-

0819 002

Fig. 1

Fig. 2

Fig. 3

0118583

Europäisches
Patentamt

**EUROPÄISCHER RECHERCHENBERICHT**

0118583
Nummer der Anmeldung

EP 83 10 2634

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y | IBM TECHNICAL DISCLOSURE BULLETIN, Band 18, Nr. 7, Dezember 1975, Seiten 2290-2291, New York, USA<br>R.S. HACKETT: "Retry circuit for array memory" * Insgesamt * | 1,2,3, 7,9 | G 06 F 11/20 |
| Y | IBM TECHNICAL DISCLOSURE BULLETIN, Band 18, Nr. 1, Juni 1975, Seiten 61-62, New York, USA<br>C.E. HOFF et al.: "Selective journaling" * Insgesamt * | 1,2 | |
| Y | IBM TECHNICAL DISCLOSURE BULLETIN, Band 12, Nr. 9, Februar 1970, Seiten 1441-1442, New York, USA<br>G.H. SMITH et al.: "Substitute memory location assignment for faulty locations" * Insgesamt * | 2 | **RECHERCHIERTE SACHGEBIETE (Int. Cl. ³)**<br><br>G 06 F 11/20 |
| A | IBM TECHNICAL DISCLOSURE BULLETIN, Band 17, Nr. 10, März 1975, Seiten 2841-2843, New York, USA<br>R. ABRAHAMSEN: "Dynamic redundancy and repair system for large mass storage unit" * Seite 2842, Zeilen 22-30 * | 4 | |
| A | US-A-3 331 058 (PERKINS) | | |

---  -/-

Der vorliegende Recherchenbericht wurde für alle Patentansprüche erstellt.

| Recherchenort<br>DEN HAAG | Abschlußdatum der Recherche<br>09-11-1983 | Prüfer<br>GUIVOL Y. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82

## EUROPÄISCHER RECHERCHENBERICHT

Europäisches Patentamt

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-3 422 402 (SAKALAY) | | |
| A | US-A-3 934 227 (WORST) | | |
| E | DE-A-3 137 152 (COZA) <br> * Insgesamt * | 1-10 | |
| A | US-A-4 020 466 (CORDI) | | |

RECHERCHIERTE SACHGEBIETE (Int. Cl. ³)

Der vorliegende Recherchenbericht wurde für alle Patentansprüche erstellt.

| Recherchenort | Abschlußdatum der Recherche | Prüfer |
|---|---|---|
| DEN HAAG | 09-11-1983 | GUIVOL Y. |